(19) Europäisches Patentamt
European Patent Office
Office européen des brevets

(11) **EP 1 860 772 A2**

(12) **EUROPEAN PATENT APPLICATION**

(43) Date of publication:
**28.11.2007 Bulletin 2007/48**

(51) Int Cl.:
***H03G 7/00*** *(2006.01)*

(21) Application number: **06124011.5**

(22) Date of filing: **14.11.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **23.05.2006 KR 20060046281**

(71) Applicant: **Samsung Electronics Co., Ltd.**
**Yeongtong-gu**
**Suwon-si, Gyeonggi-do (KR)**

(72) Inventors:
• **Kim, Nam-in**
**Yeongtong-gu**
**Suwon-si**
**Gyeonggi-do (KR)**

• **Kim, Yun-yong**
**Gwonseon-gu**
**Suwon-si**
**Gyeonggi-do (KR)**

• **Kim, Sung-woo**
**Dongan-gu**
**Anyang-si**
**Gyeonggi-do (KR)**

(74) Representative: **Benson, Christopher**
**Appleyard Lees**
**15 Clare Road**
**Halifax HX1 2HY (GB)**

(54) **Automatic input-gain control circuit and method thereof**

(57) An automatic input-gain control circuit of an audio amplifier and a method thereof are provided. If an acoustic signal exceeds a dynamic range, a gain of the acoustic signal can be automatically attenuated based on a pre-set limit level to minimize a distortion of the acoustic signal caused by clipping of the acoustic signal and limit an over-input so as to input the acoustic signal within the dynamic range. Thus, an original form of an over-input signal on a specific level or more can be maintained but only a gain of the over-input signal can be attenuated. As a result, a distortion of an output waveform caused by clipping of the output waveform can be minimized, and a harmonic distortion and a stepped high frequency noise occurring during clipping can be simultaneously removed.

FIG. 8

**Description**

The present invention relates to an automatic input-gain control circuit of an audio amplifier and a method thereof.

In general, an analog-to-digital (A to D) D-class amplifier circuit performs pulse width modulation (PWM) on an acoustic signal to transform the acoustic signal into a type of digital signal, amplifies the digital signal, and passes the amplified digital signal through a low pass filter (LPF) to recover an original analog signal.

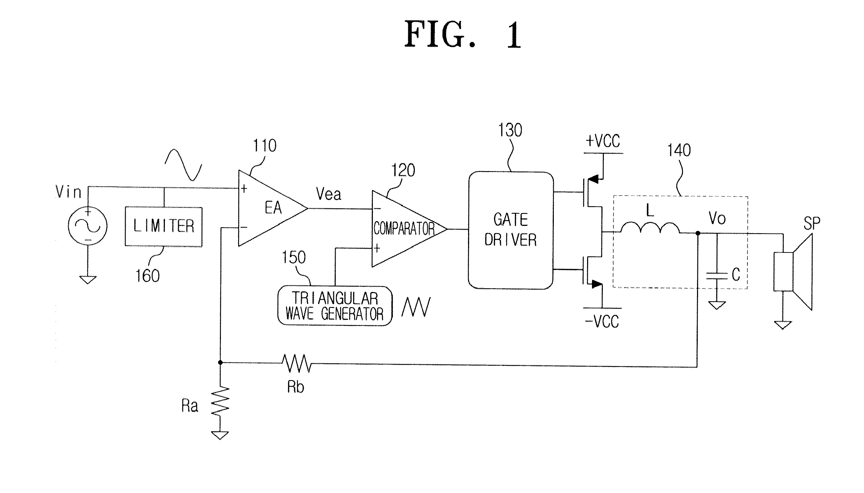

Figure 1 is a schematic diagram illustrating a structure of a conventional D-class amplifier circuit. Referring to Figure 1, the conventional D-class amplifier circuit includes an amplifier 110, a comparator 120, a gate driver 130, a low pass filter (LPF) 140, a triangular wave generator 150, and a limiter 160.

As shown in Figure 1, the amplifier 110 is realized in the form of an integrator and compares an input signal with an output signal to generate a signal Vea.

The comparator 120 compares the signal Vea with a triangular wave signal to generate a pulse width modulation (PWM) signal. The gate driver 130 amplifies the PWM signal to drive a metal-oxide-semiconductor field-effect transistor (MOSFET) switch. A signal output from the MOSFET switch, which performs a switching operation according to a gate signal, is low pass filtered by the LPF 140 and applied as an acoustic signal to a speaker SP. Here, the limiter 160 may be constituted at an input port to improve a high frequency distortion component generated when an output signal Vo of the conventional D-class amplifier circuit is clipped by a power source. A general limiter may include general zener diodes ZD1 and ZD2 or general small signal diodes D1 and D2 as shown in Figures 2A and 2B.

If an acoustic signal Vin is input to the conventional D-class amplifier circuit, the amplifier 110 having the form of the integrator compares the acoustic signal Vin with a signal fed back from the output signal Vo to generate the signal Vea corresponding to a difference between the acoustic signal Vin and the output signal Vo. The amplifier 110 compares the signal Vea with a triangular wave signal to generate a PWM signal, and an output of the amplifier 110 is PWM switched by the PWM signal. The PWM signal passes a low pass filter (LPF) 140 so as to reproduce the acoustic signal Vin. Here, the output signal Vo and the acoustic signal Vin have a gain due to feedback resistances as in Equation 1:

$$\frac{V_o}{V_{in}} = 1 + \frac{R_b}{R_a} \qquad\qquad (\text{Equation 1})$$

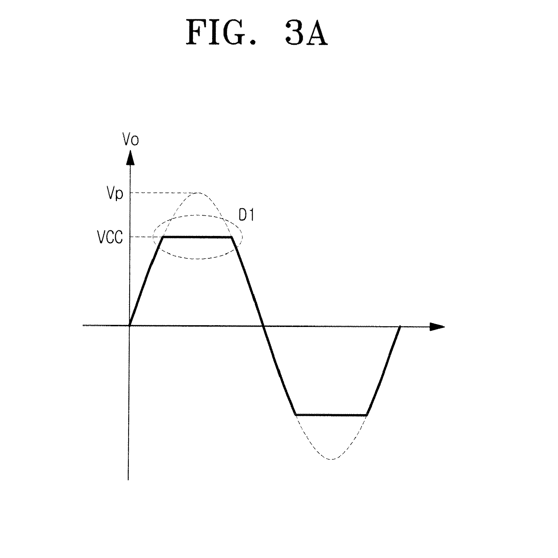

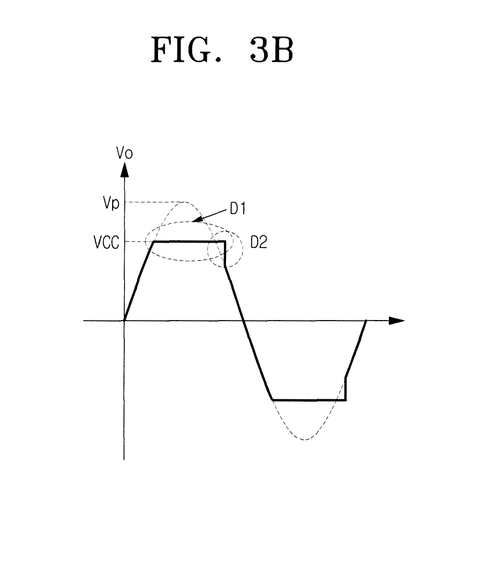

As shown in Equation 1, the output signal Vo increases with an increase in the acoustic signal Vin. If a peak vertex Vp of the output signal Vo exceeds a power supply voltage VCC due to a further increase in the acoustic signal Vin, the output signal Vo is clipped on an output level corresponding to the power voltage VCC as shown in Figure 3A or 3B. If the conventional D-class amplifier circuit is an analog amplifier circuit not a digital amplifier circuit, the output signal Vo is simply clipped occurs as shown in Figure 3A. Here, the output signal Vo has a distortion component defined as D1. However, if the conventional D-class amplifier circuit is a PWM switching amplifier which has been mainly used as a digital amplifier circuit, the output signal Vo has a waveform as shown in Figure 3B when being clipped and an additional stepped high frequency distortion component D2 at an edge of the clipped portion thereof besides the distortion component D1.

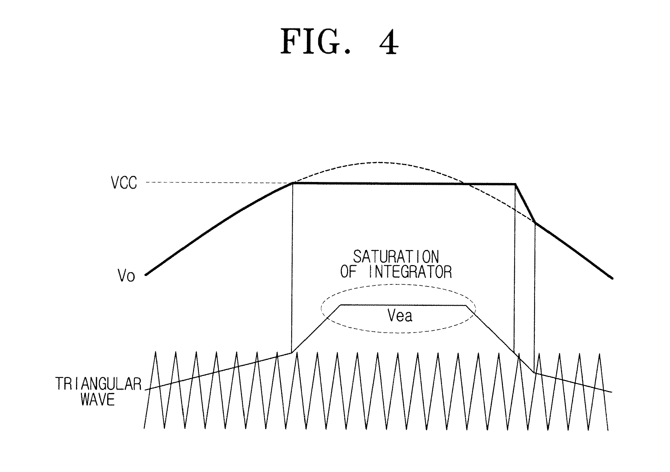

The generation of the additional stepped high frequency distortion component D2 shown in Figure 3B may be understood with reference to an internal operation waveform of a digital amplifier circuit shown in Figure 4. As shown in Figure 4, the signal Vea of the amplifier 110 gradually increases and is compared with the triangular wave signal until the output signal Vo is clipped. Thus, a duty ratio of the PWM signal gradually increases and reaches approximately 100%. Since a point of time when the duty ratio reaches 100% is a point of time when the output signal Vo of the amplifier 110 increases up to the power supply voltage VCC. Thus, although the acoustic signal Vin is further amplified after this point of time, the output signal Vo does not exceeds the power supply voltage VCC and is clipped. Here, the signal Vea output from the amplifier 110 exceeds a range of the triangular wave signal and enters a saturation state. If the acoustic signal Vin is attenuated through the peak vertex Vp and a value of the acoustic signal Vin becomes smaller than a feedback value of the clipped output signal Vo, the signal Vea output from the amplifier 110 passes the saturation state and enters the range of the triangular wave signal. A time delay necessarily occurs due to a characteristic of the integrator. The signal Vea is delayed so as to pass the saturation state and enter the range of triangular wave signal. The output signal Vo is continuously clipped for the delay time due to the characteristic of the integrator, and the signal Vea output from the amplifier 110 enters the range of the triangular wave signal and then a normal PWM operation. Thereafter, the output signal Vo varies at a steep gradient to rapidly follow an output corresponding to the acoustic signal Vin. Thus, a stepped distortion occurs.

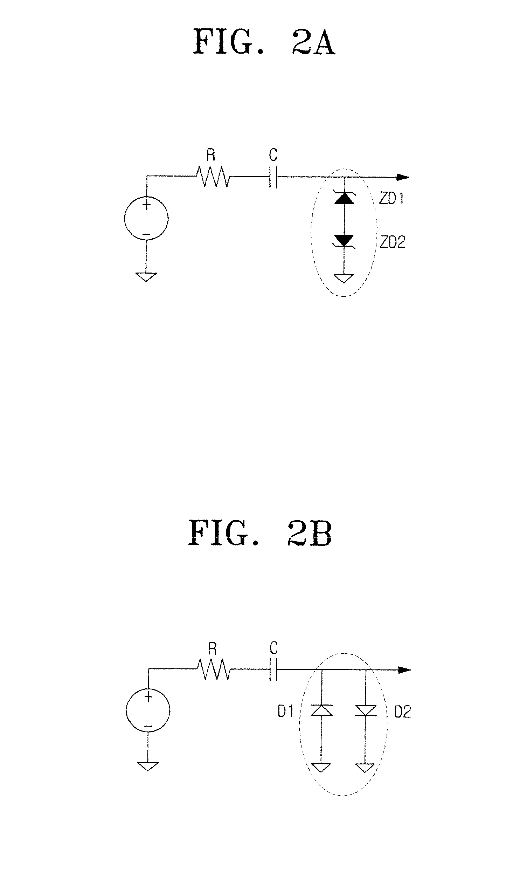

The signal Vea output from the amplifier 110 must be within the range of the triangular wave to improve the stepped high frequency distortion component D2 generated when the output signal Vea is clipped. To achieve this, an input limiter is used to limit the acoustic signal Vin to an appropriate level or less. The input limiter may generally have a structure as shown in Figure 2A or 2B. Such a structure is simply constituted, but a level to be limited is limited to a zener voltage or a diode voltage. Thus, it is difficult to freely vary the level. As a result, it is difficult to accurately cope with variations in a gain of an amplifier or a power supply voltage. Also, upper and lower portions of an over-input are clipped during limiting. Thus, an output is distorted.

According to the present invention there is provided an apparatus and method as set forth in the appended claims. Preferred features of the invention will be apparent from the dependent claims, and the description which follows.

An aspect of the present invention prevents or substantially reduces distortion of the output signal by limiting the output level when an over-input occurs.

It is another aspect of the present invention to prevent or substantially reduce clipping of an output signal when an over-input occurs.

It is another aspect of the invention to variably limit the gain of an acoustic signal to allow the use of same power source for products having different power requirements.

The forgoing aspects of the present invention can be accomplished by providing an automatic input-gain control circuit for automatically attenuating a gain of an acoustic signal based on a pre-set limited level to minimize a distortion of the acoustic signal caused by clipping of the acoustic signal and limit an over-input of the acoustic signal so as to input the acoustic signal within a dynamic range if the acoustic signal is not input within the dynamic range in an audio apparatus including an acoustic amplifier and a switching amplifier, and a method thereof.

According to an aspect of the present invention there is provided an automatic input-gain control circuit of an audio amplifier including: an output comparator comparing a voltage of an output signal of the audio amplifier with a reference voltage generated based on a threshold voltage Vth; and an input gain adjuster automatically adjusting a voltage of an input signal of the audio amplifier according to the comparison result of the output comparator so that the voltage of the output signal is within the reference voltage.

The reference voltage may be a voltage corresponding to a difference between a power supply voltage VCC and the threshold voltage Vth.

The threshold voltage Vth may be calculated using Equation $"V_{th} = V_{DZ1} - 2V_{D1}"$, wherein $V_{DZ1}$ denotes a backward voltage of a zener diode DZ1, and $V_{D1}$ denotes a forward voltage between an emitter and a base of a transistor Q1 or a forward voltage of a diode D1.

The output comparator may include: a detector detecting whether the voltage of the output signal exceeds the reference voltage; and a transmitter transmitting the voltage of the output signal to the input gain adjuster according to the detection result of the detector.

The detector may be a constant voltage element, and the constant voltage element may include a zener diode.

The transmitter may be a switching element, and the switching element may include a transistor.

The input gain adjuster may be a variable resistor element adjusting an input impedance to attenuate an input gain so that the voltage of the output signal is within the reference voltage if the voltage of the output signal exceeds the reference voltage. The variable resistor element may include a junction field effect transistor (J-FET).

If the detector detects that the voltage of the output signal exceeds the reference voltage, the output comparator may transmit the output signal to the input gain adjuster through the transmitter.

The output comparator may include: a first comparator comparing the voltage of the output signal with a plus reference voltage; and a second comparator comparing the voltage of the output signal with a minus reference voltage.

According to another aspect of the present invention, there is provided a method of automatically controlling an input gain of an audio amplifier, including: comparing a voltage of an output signal of an audio amplifier with a reference voltage generated based on a threshold voltage Vth; and automatically adjusting a voltage of an input signal of the audio amplifier according to the comparison result so that the voltage of the output signal is within the reference voltage.

The reference voltage may be a voltage corresponding to a difference between a power supply voltage VCC and the threshold voltage Vth.

The comparing of the voltage of the output signal of the audio amplifier with the reference voltage generated based on the threshold voltage Vth may include: detecting whether the voltage of the output signal exceeds the reference voltage; and outputting the output signal according to the detection result.

The detecting of whether the voltage of the output signal exceeds the reference voltage may be performed using a constant voltage element.

The output signal of the audio amplifier may be output using a switching element.

If the voltage of the output signal exceeds the reference voltage, an input impedance may be adjusted using a variable resistor element to attenuate an input gain so that the voltage of the output signal is within the reference voltage.

For a better understanding of the invention, and to show how embodiments of the same may be carried into effect, reference will now be made, by way of example, to the accompanying diagrammatic drawings in which:

Figure 1 is a schematic diagram illustrating a structure of a conventional D-class amplifier circuit;

Figures 2A and 2B are circuit diagrams illustrating a conventional limiter circuit;

Figures 3A and 3B are graphs illustrating clipping of an output voltage occurring when a peak vertex Vp of the output voltage exceeds a power supply voltage VCC;

Figure 4 is a graph illustrating an internal operation waveform of an audio amplifier circuit;

Figure 5 is a circuit diagram illustrating an automatic input-gain control circuit of an audio amplifier according to an embodiment of the present invention;

Figure 6 is a circuit diagram illustrating an automatic input-gain control circuit according to another embodiment of the present invention;

Figure 7 is a circuit diagram illustrating an equivalent circuit of an automatic input-gain control circuit according to an embodiment of the present invention; and

Figure 8 is a graph illustrating a waveform of an output voltage output within a reference voltage according to an embodiment of the present invention.

Throughout the drawings, the same drawing reference numerals will be understood to refer to the same elements, features, and structures.

The matters defined in the description such as a detailed construction and elements are provided to assist in a comprehensive understanding of the embodiments of the invention and are merely exemplary. Accordingly, those of ordinary skill in the art will recognize that various changes and modifications of the embodiments described herein can be made without departing from the scope and spirit of the invention. Also, descriptions of well-known functions and constructions are omitted for clarity and conciseness.

Hereinafter, exemplary embodiments of the present invention will be described in detail with reference to the accompanying drawings.

Certain embodiments of the present invention are characterized in that an over-input signal is attenuated to prevent a clipping distortion D1 caused by an over-input and an over-output and a stepped high frequency distortion D2 caused by a saturation of an internal block of the audio amplifier, so that an output signal does not approach a power supply voltage VCC of the audio amplifier but is within a threshold voltage Vth regardless of variations in a gain of the audio amplifier and the power supply voltage VCC. Also, a whole gain may be attenuated instead of cutting over-input components to maintain an original form of the input signal and minimize a distortion of the input signal so as to limit an input level. In addition, the threshold voltage Vth may be adjusted with respect to the power voltage VCC to vary an output limited level so as to design an amplifier having various output powers depending on products. Thus, the amplifier may be designed to have the same speaker impedance and power supply voltage as a previously designed amplifier so as to share a speaker and a power source block.

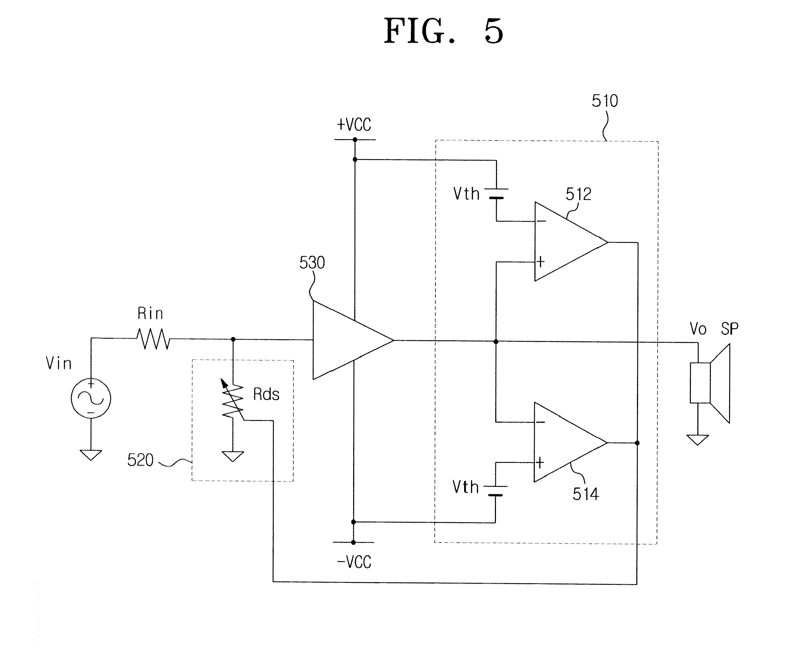

Figure 5 is a circuit diagram illustrating an automatic input-gain control circuit of an audio amplifier according to an embodiment of the present invention. Referring to Figure 5, the automatic input-gain control circuit of the audio amplifier according to the present embodiment includes an output comparator 510, an input gain adjuster 520, a switching amplifier 530, and a speaker SP.

The automatic input-gain control circuit may further include the comparator 120, the gate driver 130, the low pass filter (LPF) 140, and the triangular wave generator 150 as shown in Figure 1. That is, the automatic input-gain control circuit of the present invention may be incorporated in to a prior art device such as the one shown in Figure 1. The structures of the comparator 120, the gate driver 130, the LPF 140, and the triangular wave generator 150 have been described above and thus, their detailed descriptions will be omitted herein.

The output comparator 510 compares a voltage of an output signal Vo (hereinafter called "output voltage") with a reference voltage for inputting an acoustic signal of the audio amplifier within a power supply voltage VCC. The output comparator 510 includes first and second comparators 512 and 514 as shown in Figure 5. The first comparator 512 compares the output voltage with a threshold voltage Vth of a plus power supply voltage +VCC. The second comparator 514 compares the output voltage with a threshold voltage Vth of a minus power supply voltage - VCC. Here, the threshold voltages Vth mean margin voltages for disallowing an output signal to reach the power supply voltage VCC.

The input gain adjuster 520 automatically adjusts a voltage of the acoustic signal to input the acoustic signal within the power supply voltage VCC according to the comparison result of the output comparator 510. In other words, the input gain adjuster 520 attenuates a whole gain of the acoustic signal so as to maintain an original form of the acoustic signal and minimum a distortion of the acoustic signal. For this purpose, the input gain adjuster 520 operates as a voltage control variable resistor Rds for adjusting an input impedance of the acoustic signal.

The switching amplifier 530 amplifies the acoustic signal.

In the automatic input-gain control circuit of the audio amplifier having the above-described structure shown in Figure 5, the acoustic signal generated by an operation power source is applied to the switching amplifier 530 through an input resistor Rin. The output comparator 510 and the speaker SP are connected to an output port of the switching amplifier 530, and the input gain adjuster 520 for adjusting the acoustic signal is connected to an input port of the switching amplifier 530. The first comparator 512 of the output comparator 510 is connected to the plus power supply voltage +VCC above the switching amplifier 530, and the second comparator 514 of the output comparator 510 is connected to the minus power supply voltage -VCC under the switching amplifier 530.

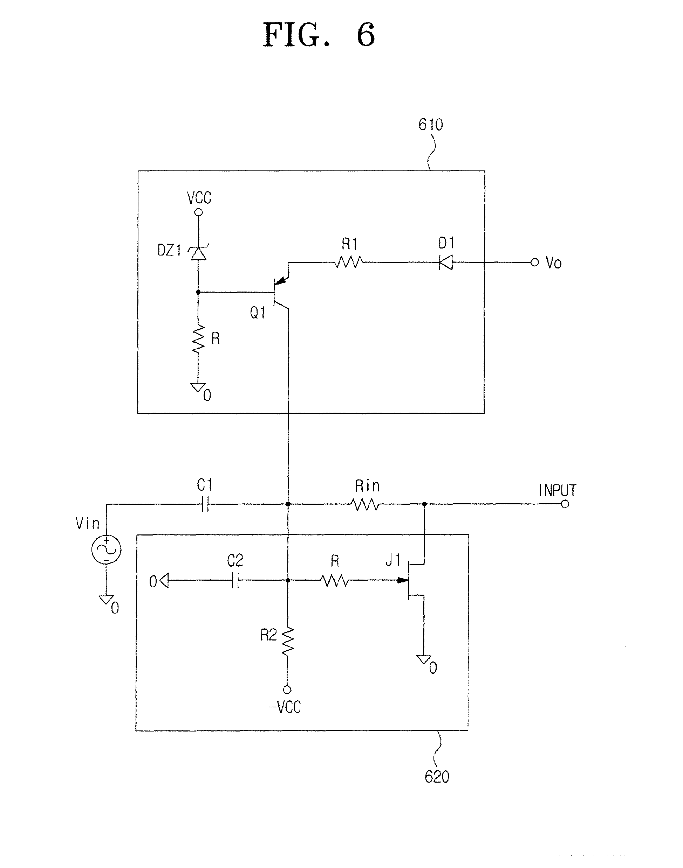

Figure 6 is a circuit diagram illustrating an automatic input-gain control circuit according to another embodiment of the present invention. The automatic input-gain control circuit according to the present embodiment includes a detection transmitter 610 and an input adjuster 620. Here, the detection transmitter 610 and the input adjuster 620 are exemplary implementations of the output comparator 510, and the input gain adjuster 520 of Figure 5 respectively.

The detection transmitter 610 includes a detector and a transmitter. The detector operates when an output voltage exceeds a reference voltage. The transmitter is turned on depending on the operation of the detector to transmit the output voltage to the input adjuster 620. Here, the reference voltage is a voltage obtained through a subtraction of a threshold voltage Vth from a power supply voltage VCC. In other words, the reference voltage corresponds to a difference between the power supply voltage VCC and the threshold voltage Vth.

As shown in Figure 6, the detector may be a constant voltage element including a zener diode DZ1, and the transmitter may be a switching element including a transistor Q1.

In more detail, in the detection transmitter 610, the zener diode DZ1 is connected to a resistor R in series between the power supply voltage VCC and a ground voltage, and a base of the transistor Q1 is connected to a connection point between the zener diode DZ1 and the resistor R. A diode D1 is connected to a resistor R1 in series between an emitter of the transistor Q1 and an output port, and a collector is connected to the input adjuster 620. Here, the transistor Q1 may be a PNP type transistor.

A capacitor C1 is connected to an input resistor Rin in series between a voltage of an input signal Vin (hereinafter called "input voltage") and an input port INPUT. The input adjuster 620 including a junction field effect transistor (J-FET) J1 is connected to a connection point between the input port INPUT and the input resistor Rin. In other words, the input adjuster 620 may include an element operating as a variable resistor or may include the J-FET J1 as shown in Figure 6.

A drain of the J-FET J1 of the input adjuster 620 is connected to the connection point between the input port INPUT and the input resistor Rin. A source of the J-FET J1 is grounded, and a capacitor C2 is connected to a resistor R in series between a gate and a ground. A minus power supply voltage -VCC is connected to a connection point between the capacitor C2 and the resistor R through a resistor R2, and a collector of the transistor Q1 of the detection transmitter 610 is connected to the connection point between the capacitor C2 and the resistor R.

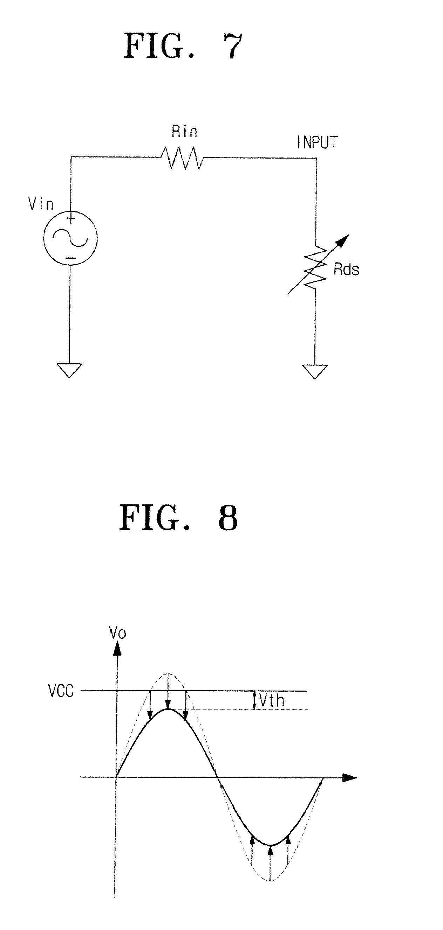

An equivalent circuit of the automatic input-gain control circuit shown in Figure 6 is shown in Figure 7. In other words, the equivalent circuit includes an input voltage, an input resistor Rin, and a variable resistor Rds and adjusts an intensity of the input voltage through the variable resistor Rds.

The operation of the automatic input-control circuit of the audio amplifier according to the present embodiment will now be described.

For the description of the operation of the automatic input-gain control circuit, it is supposed that the automatic input-gain control circuit shown in Figure 6 is constituted as an input part of the audio amplifier shown in Figure 1.

Here, the automatic input-control circuit operates when the output voltage exceeds the threshold voltage Vth defined as a margin with the power supply voltage VCC. Here, the threshold voltage Vth is defined as in Equation 2:

$$V_{th} = V_{DZ1} - 2V_{D1} \qquad \text{(Equation 2)}$$

wherein $V_{DZ1}$ denotes a backward voltage of the zener diode DZ1, and $V_{D1}$ denotes a forward voltage between the emitter and the base of the transistor Q1 or a forward voltage of the diode D1. Thus, if the output voltage is greater than the difference between the power supply voltage VCC and the threshold voltage Vth, the transistor Q1 operates so as to increase a gate voltage of the J-FET J1 of the input adjuster 620. If the increased gate voltage is greater than or equal to a turn-on voltage - $V_{G.ON}$ of the J-FET J1, an impedance between the drain and source of the J-FET J1 varies and decreases. In this case, the input adjuster 620 may be equalized as shown in Figure 7. Thus, a voltage $V_{INPUT}$ substantially input to the input port INPUT of the audio amplifier is expressed with respect to the voltage Vin of the input signal as in Equation 3:

$$V_{INPUT} = (\frac{R_{ds}}{R_{in} + R_{ds}}) * V_{in} \qquad (\text{Equation 3})$$

As shown in Equation 3, variable resistance Rds decreases with an increase in an over-input state. Thus, the voltage $V_{INPUT}$ is attenuated. As a result, a peak value of a substantially output voltage is fixed to and does not exceed the power supply voltage VCC and the threshold voltage Vth. A gain of the input signal is attenuated as in Equation 3 to satisfy the conditions of Equation 3. Thus, only a gain of the output signal is attenuated with an original form of the output signal maintained. If a level of the input signal is in a normal state not in the over-input state, the transistor Q1 and the J-FET J1 are turned off. Thus, Rds is greater than the input resistor Rin, and the voltage $V_{INPUT}$ is equal to the input voltage. As a result, the input signal is attenuated to be equal to an original acoustic signal and then input to the input port of the audio amplifier.

As described, in an audio apparatus including an acoustic amplifier and a switching amplifier according to the present invention, if an input acoustic signal exceeds a dynamic range, a gain of the input acoustic signal is automatically attenuated based on a pre-set limit level so as to input the input acoustic signal within the dynamic range. Thus, an acoustic signal equal to an original signal is output, a distortion of the acoustic signal is minimized when the acoustic signal is clipped, a stepped distortion is removed, and an over-input is limited.

As described above, in an automatic input-gain control circuit and a method thereof according to the present invention, only a gain of an over-input signal more than or equal to a specific level can be attenuated instead of cutting the over-input signal. Thus, a distortion of an output waveform caused by clipping of the output waveform can be minimized. In particular, a switching amplifier can prevent a saturation of an internal block to simultaneously remove a harmonic distortion and a stepped high frequency noise occurring during clipping. Also, a linear analog amplifier can attenuate only the gain with maintaining an original form of the over-input signal instead of simply clipping the over-input signal so as to minimize a distortion of an output signal.

Electronic appliance having an audio function can use an identical power supply voltage to arbitrarily adjust a reference voltage of an output comparator circuit operating as a gain attenuating circuit so as to limit an output level. Thus, an effect of varying the power source or a speaker impedance can be obtained without actually doing so. Accordingly, a power supply voltage and a speaker impedance of a product having various output specifications can be standardized.

Although a few preferred embodiments have been shown and described, it will be appreciated by those skilled in the art that various changes and modifications might be made without departing from the scope of the invention, as defined in the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. An automatic input-gain control circuit of an audio amplifier, comprising:

   an output comparator (510, 610) comparing a voltage of an output signal of the audio amplifier with a reference voltage generated based on a threshold voltage Vth; and
   an input gain adjuster (520, 620) automatically adjusting a voltage of an input signal of the audio amplifier according to the comparison result of the output comparator (510, 610) so that the voltage of the output signal is within the reference voltage.

2. The automatic input-gain control circuit of claim 1, wherein the reference voltage is a voltage corresponding to a difference between a power supply voltage VCC and the threshold voltage Vth.

3. The automatic input-gain control circuit of claim 1 or 2, wherein the threshold voltage Vth is calculated using Equation "$V_{th} = V_{DZ1} - 2V_{D1}$", wherein $V_{DZ1}$ denotes a backward voltage of a zener diode DZ1, and $V_{D1}$ denotes a forward voltage between an emitter and a base of a transistor Q1 or a forward voltage of a diode D1.

4. The automatic input-gain control circuit of any preceding claim, wherein the output comparator (610) comprises:

a detector detecting whether the voltage of the output signal exceeds the reference voltage; and
a transmitter transmitting the voltage of the output signal to the input gain adjuster according to the detection result of the detector.

5. The automatic input-gain control circuit of claim 4, wherein the detector is a constant voltage element.

6. The automatic input-gain control circuit of claim 5, wherein the constant voltage element comprises a zener diode.

7. The automatic input-gain control circuit of any of claims 4 to 6, wherein the transmitter is a switching element.

8. The automatic input-gain control circuit of claim 7, wherein the switching element comprises a transistor.

9. The automatic input-gain control circuit of any preceding claim, wherein the input gain adjuster is a variable resistor element adjusting an input impedance to attenuate an input gain so that the voltage of the output signal is within the reference voltage if the voltage of the output signal exceeds the reference voltage.

10. The automatic input-gain control circuit of claim 9, wherein the variable resistor element comprises a J-FET (junction field effect transistor).

11. The automatic input-gain control circuit of any of claims 4 to 10, wherein if the detector detects that the voltage of the output signal exceeds the reference voltage, the (510, 610) transmits the output signal to the input gain adjuster through the transmitter.

12. The automatic input-gain control circuit of any of claims 1 to 3, wherein the output comparator (510) comprises:

a first comparator (512) comparing the voltage of the output signal with a plus reference voltage; and
a second comparator (514) comparing the voltage of the output signal with a minus reference voltage.

13. A method of automatically controlling an input gain of an audio amplifier, comprising:

comparing a voltage of an output signal of an audio amplifier with a reference voltage generated based on a threshold voltage Vth; and
automatically adjusting a voltage of an input signal of the audio amplifier according to the comparison result so that the voltage of the output signal is within the reference voltage.

14. The method of claim 13, wherein the reference voltage is a voltage corresponding to a difference between a power supply voltage VCC and the threshold voltage Vth.

15. The method of claim 13 or 14, wherein the comparing of the voltage of the output signal of the audio amplifier with the reference voltage generated based on the threshold voltage Vth comprises:

detecting whether the voltage of the output signal exceeds the reference voltage; and
outputting the output signal according to the detection result.

16. The method of claim 15, wherein the detecting of whether the voltage of the output signal exceeds the reference voltage is performed using a constant voltage element.

17. The method of any of claims 13 to 16, wherein the output signal of the audio amplifier is output using a switching element.

**18.** The method of any of claims 13 to 17, wherein if the voltage of the output signal exceeds the reference voltage, an input impedance is adjusted using a variable resistor element to attenuate an input gain so that the voltage of the output signal is within the reference voltage.

# FIG. 1

# FIG. 2A

# FIG. 2B

# FIG. 3A

# FIG. 3B

# FIG. 4

VCC

Vo

SATURATION
OF INTEGRATOR

Vea

TRIANGULAR
WAVE

FIG. 5

510

512

514

Vth

Vth

Vo  SP

+VCC

−VCC

530

Rds

Rin

520

Vin

# FIG. 6

# FIG. 7

# FIG. 8